# EUROPEAN PATENT APPLICATION

(11) **EP 4 438 765 A1**
(43) Date of publication of application: **02.10.2024**
(21) Application number: 23164301.6
(22) Date of filing: 27.03.2023
(51) Int. Cl.: C23C 14/02, C23C 14/54, C23C 14/56, C23C 16/50, C23C 16/54, F27D 11/08, F27D 11/12, H01J 37/32, F27D 99/00

(54) **METHOD AND DEVICE FOR PLASMA HEATING OF THE INTERNAL WALLS OF A VACUUM FURNACE**

(71) Applicant: voestalpine Stahl GmbH, 4020 Linz (AT)
(72) Inventor: VANDEN BRANDE, Pierre, 6377 Seelisberg (CH)
(74) Representative: Callewaert, Koen

(57) **Abstract**

Method and device for heating the walls (17) of a vacuum furnace (8,9,30), said walls (17) having an electric conductive surface (20), wherein a plasma is generated in a gas at a pressure lower than 1 mbar in the vacuum furnace (8,9,30) between said walls (17) and an anode (18). A voltage bias is generated between the plasma and said surface (20) of the walls (17) by polarising the surface (20) negatively with respect to the anode (18). The temperature of the walls (17), in particular of the conductive surface (20), is regulated by regulating the power transfer of the plasma to the walls (17) by controlling the electrical power supply through said voltage bias.

## Description

### A. General description of the invention and prior art

The invention concerns a method for heating an internal volume in a vacuum furnace by heating the walls delimiting this internal volume. Said walls form a thermal shield and have an electric conductive surface directed towards said internal volume. A plasma is generated between said walls and an anode present in the internal volume in a gas at a pressure lower than 1 mbar.

Thus this invention relates in general to a method and a device aiming to the controlled heating and cooling of the inside walls of the thermal shield of a vacuum furnace. Such a vacuum furnace is also referred to as a plasma furnace in the description below.

### B. Problems of the prior art

According to the prior art, a vacuum furnace is heated according to the following principles :
(i) by radiation heat transfer from electrical heating resistances that must be maintained at a higher temperature than the walls that are to be heated. Hence the possible maximal temperature of the walls is limited by the maximal temperature of the heating resistances. Indeed, in order to have a heat transfer towards the furnace internal walls, a temperature difference is needed between the heating resistances and the surfaces of the heated wall. This heat transfer is furthermore limited by the emissivity of the heating resistances and the emissivity of the walls, which emissivity is always less than one.
(ii) by inductive coupling. However, it is not possible to apply such inductive coupling over the whole internal area of the vacuum furnace because of the limited size of the coupling inductors. Another drawback of heating by inductive coupling is the unavoidable parasitic coupling with other areas of equipment than the walls. Still another drawback of the inductive coupling is a lower efficiency compared to other heating methods due to power losses in the inductors that need to be cooled.

A further disadvantage of these heating methods according to the prior art, is the rather slow heating rate of the walls of the vacuum furnace and thus of its internal volume.

### C. The aim of the invention

The aim of the invention is to overcome the above disadvantages of the prior art. Moreover, the invention aims to propose an energy efficient method for heating a vacuum furnace at higher temperatures while enabling better temperature control than in the prior art. A further object of the invention is to enable a much faster temperature rise of the inner walls of the vacuum furnace compared to the methods of the prior art.

To this aim, a voltage bias is generated between the plasma and said conductive surface of the walls by polarising said surface negatively with respect to the anode. The temperature of said walls, in particular of said surface, is regulated by regulating the power transfer of the plasma to the walls by controlling the electrical power supply through said voltage bias.

In general, according to the invention, the vacuum furnace is heated by maintaining a controlled power by voltage bias between the walls and a plasma generated in the internal volume of the vacuum furnace. Thus the vacuum furnace, in particular its internal volume, is heated by heating the internal surface of the walls.

Heating the vacuum furnace in such a way presents the following advantages over the prior art :
- Direct heating of the totality of the area of the internal walls of the thermal shielding of the vacuum furnace by dissipating the energy of a plasma at the surface of the walls independently of their temperature. This obviates the use of the less energy efficient heating methods of the prior art.
- Improved temperature control of the totality of the area of the internal walls of the vacuum furnace. Such improved control is obtained by plasma heating the overall area of the walls by directly applying electrically controlled power density to these walls via the plasma. This allows better temperature control than with heating by radiation or inductive heating that produce uneven indirect heating of the walls due to the comparatively smaller areas of the heating devices, either resistances or inductors, compared to the internal area of the vacuum furnace. Thus the invention allows uniform heating of the surface of the walls adjacent to the internal volume of the vacuum furnace.
- Higher possible temperature of the furnace walls than with the prior art that uses heating resistances. Indeed, the temperature of the heating resistance is necessarily higher than that of the walls to allow radiation heat transfer to the walls. Thus, in the invention, the temperature of the walls is not limited by the maximum temperature that can be reached by the heating resistances.
- Possibility of much faster rise of the temperature of the inner walls of the vacuum furnace compared to the methods of the prior art. This because the invention allows heating the totality of the vacuum furnace internal wall area at power densities up to 30 W/cm² for a smaller mass of thermal shielding and heating equipment than what is possible with the prior art. In the prior art, the mass of radiators adds to that of the thermal shields.
- Because of the very fast heating, typically less than 10 minutes to reach the maximal temperature at the internal walls of the thermal shielding of the vacuum furnace, it is possible, contrary to the prior art, to heat the furnace while maintaining a load to be treated at significantly lower temperature than the thermal shielding, i.e. at a lower temperature than the surface of the walls. That presents a major advantage when the vacuum furnace is equipped with a plasma evaporator aiming to coat a substrate that must necessarily be kept at a much lower temperature than the temperature of the internal walls of the vacuum furnace and at a lower temperature than the temperature of the material to be evaporated to allow the deposition of the evaporated material predominately on the surface of the substrate.

### D. Summary of the invention

According to the invention, a voltage bias is generated between the plasma and the surface of the walls of the vacuum furnace by polarising this surface negatively with respect to the anode. The temperature of these walls, in particular of said surface, is regulated by regulating the power transfer of the plasma to the walls by controlling the electrical power supply through said voltage bias.

In a preferred embodiment of the invention, the surface area of said anode in said internal volume is smaller than the total area of the side of said walls directed towards said internal volume.

Advantageously, said gas is an inert gas comprising at least one of helium, argon, neon or xenon, that is introduced into the internal volume in which a pressure is maintained between, preferably, 0.001 and 0.1 mbar.

In an interesting manner, a crucible containing a material is present in the internal volume and is polarized negatively against the anode and the material is evaporated in order to produce a vapor of the material. When a preset temperature is reached at said electric conductive surface of the walls, supply of said gas to the internal volume is terminated and the plasma is maintained in said vapor.

According to a specific embodiment of the invention, power transfer from the plasma to the material in the crucible is then increased, for evaporating said material contained in the crucible, by raising the electrical power supply through the voltage bias between the crucible containing the material and said anode.

According to an interesting embodiment, a magnetic field is generated in said internal volume oriented substantially parallel to the surface of the material contained in the crucible to enable a post-magnetron discharge.

The invention also relates to a method for treating a substrate located in the vacuum furnace or one or more substrates moved along or through the internal volume of the vacuum furnace. The surface of the walls of the vacuum furnace is plasma heated as explained above.

The substrate to be treated is brought into contact with the vapor contained in the internal volume, while the substrate is electrically insulated from said walls and from said anode.

According to a particular embodiment of this method, the substrate is brought into contact with said vapor after said preset temperature has been reached at the surfaces of the walls directed towards the internal volume and after terminating supply of gas to the internal volume.

Preferably, the substrate is kept thermally shielded from the internal volume until at least said preset temperature is reached at the surfaces of the walls directed towards the internal volume.

Advantageously, after said substrate is brought into contact with the vapor, the electrical power delivered through the voltage bias between the crucible containing the material and said anode is raised.

Further, the invention concerns also a device for plasma treatment of a substrate. This device comprises a vacuum furnace with an internal volume delimited by walls forming a thermal shield and having a side directed towards said internal volume. This side of the walls has an electric conductive surface. An anode is provided in the internal volume of the vacuum furnace that permits to generate a plasma in the internal volume. The vacuum furnace is usually arranged within a vacuum vessel.

The device according to the invention, is characterised in that the electric conductive surface of the walls is adapted to be negatively polarised against said anode. Further, a power supply is provided allowing to apply voltage bias between the plasma and the electric conductive surface of the walls by polarising this electric conductive surface negatively with respect to the anode. A controller is provided for regulating the temperature of this surface of the walls by regulating the power transfer of the plasma to the walls by controlling the electrical power supply through said voltage bias.

Thus, in general, the invention presents :
- **(i)** a method for controlled plasma heating of the internal sides of the walls of a vacuum furnace possibly coupled to a plasma evaporator, and/or a device for electric polarization of the substrate or load to be treated. Such a plasma evaporator comprises at least one crucible above which a plasma is realized by polarizing negatively the crucible against an anode, being well known by those skilled in the art for evaporating a material or an element contained in the crucible.

In this method for controlled plasma heating of the internal walls of the vacuum furnace, a plasma is generated in a gas at pressure lower than 1 mbar between these walls, constituting a cathode, and an anode secured in the internal volume of the furnace. The anode area is notably smaller than the total area of the internal walls of the vacuum furnace in order to facilitate reflections of primary electrons onto the furnace walls and hence stabilize a plasma in the internal volume even in absence of magnetic confinement of the discharge electrons. The anode area is typically less than 10% of the total area of the surface of the internal walls of the vacuum furnace adjacent to the internal volume.

According to the method, starting from room temperature and after the system has been vacuum pumped down to a pressure lower than 10⁻⁴ mbar, a rare gas is introduced into the internal volume of the vacuum furnace, preferably, at a pressure in the range 0.01 - 0.1 mbar. This rare gas comprises He or Ar, for example, or a mixture of these, but Ne and Xe could also be used. The internal walls of the thermal shield of the furnace are polarized negatively against the anode at controlled power until a temperature setpoint is reached at the internal surface of the walls, while the substrate or load to be treated is electrically insulated from these internal walls of the vacuum furnace.

In the case of the presence of a plasma evaporator in the vacuum furnace, the rare gas supply in the furnace is cut off when said temperature setpoint is reached at the surface of the walls and the discharge or plasma is maintained solely in the vapor of the element being evaporated from the plasma evaporator.

A substrate or successive substrates are treated by the vapor and when the treatment is ended, the electric power supply coupling heating power by plasma to the internal walls of the furnace is switched off and the rare gas pressure is raised to a pressure typically higher than 0.1 mbar, preferably between 1 and 10 mbar, for fast cooling of the furnace thermal shields until a temperature threshold, generally lower than 100°C, is reached allowing the venting of the system to atmospheric pressure.
- **(ii)** a device comprising a vacuum vessel in which is secured a thermal shielding whose internal layer is made of an electrically conducting material in order to be negatively polarized against one or several counter electrode(s) or anode(s) protruding inside of the volume enclosed by this thermal shielding. The thermal shielding thus comprises walls that form a vacuum furnace and that delimit an internal volume of this vacuum furnace. The anode presents a significantly smaller developed area than the total area of the internal walls of the thermal shielding, typically less than 10% of that area.

Depending on the applications, two types of arrangements can be defined. In a first arrangement, the substrate to be treated crosses the vacuum furnace through one or more openings. A typical example of such an application is the coating of a substrate such as a steel strip crossing the thermally shielded volume by two openings, an entry opening and a exit opening. Such an arrangement can be used for substrates of any shape and/or material that are moved trough the vacuum furnace for treatment of the surface of the substrates. The substrate to be treated is electrically isolated from the internal walls of the furnace and from the anode(s) in order to be able to take any fixed potential against the potential of the anode(s) by use of an auxiliary power supply.

In a second arrangement the vacuum furnace forms a thermally shielded and closed internal volume having openings for vacuum pumping and introduction of the required gases. The substrate to be treated is placed in the this internal volume. This second type of arrangements targets the typical applications of high vacuum furnaces and retorts such as thermal treatment of substrates, vacuum brazing and coating of products in a retort.

In both type of arrangements, the substrate is electrically isolated from the internal walls of the furnace and from the anode in order to be able to take any potential against the potential of the anode by use of an auxiliary power supply.

The thermal shield is preferably formed by a stack of metal shields, preferably of molybdenum, but any metal, semi-metallic, semiconducting material, composite or otherwise, can be used. It is however important that the internal side of the shield of the furnace facing the anode(s) is electrically conductive and able to be polarized negatively against the anode(s) protruding in the vacuum furnace. A carbon-based material such as carbon felt composite etc., can be used as electrical insulating material to insulate said internal side of the thermal shield from other parts of the furnace. The thermal shield forms preferably a casing in which the stack of insulating material is enclosed.

In case of evaporation of a material in the vacuum furnace, the thermal shield must be gas-tight enough to avoid contamination of the enclosed thermal insulation material by the evaporated element. This thermal shield preferably forms a confinement or containment enclosure for the vapor of evaporated material.

Said first type of arrangements can be adapted to treat discrete products running one behind the other in case of a semi-continuous process or it can be provided for a continuous process wherein continuously moving continuous products are treated. Such discrete products comprise, for example, successive long steel products, whereas a continuous product is, for example, a steel strip. These discrete products or continuous products thus form substrates that are moved along or through the vapor while maintaining the system under working conditions. To this end, the vacuum furnace presents at least one opening for gas pumping and for passage of the product in and out of the vacuum furnace. A typical application is the coating of a continuous steel strip that crosses continuously the vacuum furnace through entry and exit openings provided to this effect. According to another example, a coating is applied to successive steel products of limited length that pass sequentially through the vacuum furnace through the inlet and outlet openings.

In case of a batch process, where the product or substrate to be treated is placed in the vacuum furnace before vacuum pumping and heating the inner walls of the furnace, the vacuum furnace is completely gas-tight except at the gas inlet and vacuum pump ports. The vacuum pumping ports are thermally shielded and protected by a baffle made of parallel channels, that could also be chevron baffles, close enough to prevent any plasma diffusion in the vacuum vessel and, in the specific case of coating, to prevent any deposit of the evaporated material on the internal walls of the vacuum vessel. In this last case, the baffle is preferably water-cooled. More details will be given in the description of the figures and examples below. The thermal shield of the furnace is advantageously supported and thermally shielded towards the vacuum vessel internal walls by a water-cooled shield. Of course, any other fluid or more general means, such as for example Peltier cells, can be used for cooling this cooled-shield. The cooled-shield is preferably at the same electric potential as the electric potential of the thermal shield and electrically insulated from the vacuum vessel which is generally at grounded potential.

Openings are provided through the thermal shield and through the cooled-shield allowing the passage, with electrical insulation, of mechanical support shafts and electrical leads to the different parts of equipment, i.e., anode(s), frame supporting the loads to be treated in case of a batch process, evaporator electric leads and supporting frame if applicable. In all cases, the elements that cross such corresponding openings in the thermal and cooled shields are electrically insulated from the shields by use of a ceramics or by leaving clearances between the elements and the openings. In the latter case, the clearance is small enough to prevent plasma diffusion outside the thermal shield and small enough to limit the loss of gas or vapor towards the internal walls of the vacuum vessel, as is well known to those skilled in the art. Advantageously, in order to prevent any parasitic plasma in the volume of the vacuum vessel outside the cooled-shield of the vacuum furnace, the external surface of the cooled-shield is covered over most of its surface by an electric insulating layer formed by insulating material or by a metallic electric shield secured at a distance of less than 5 mm from the external surface of the cooled-shield and electrically insulated from the cooled-shield. If the presence of an axial magnetic field is required in the volume of the vacuum furnace to enhance gas ionization in the internal volume thereof, the electromagnets, magnets and yokes needed to produce such field will be secured preferably in the free space between the electrical insulation layer and the internal surface of the vacuum vessel containing the equipment.
- **(iii)** one or several plasma evaporator(s) accommodated in the plasma furnace, wherein evaporation is, preferably, enhanced by post-magnetron discharge(s). Such a plasma evaporator comprises one or several crucibles made of electrically conducting refractory materials and containing a material to be evaporated. A magnetic induction field is distributed substantially throughout the entire volume of the plasma furnace and oriented such as to extend substantially parallel to the surface and along the longest axis of the crucible(s).

A preferred method for generating the magnetic field within the internal volume of the plasma furnace, while minimising the magnetic induction field outside of the structure of permanent magnets, is the use of Halbach arrays, i.e. cladded magnets and magnetic yokes secured on the electric insulating layer. Such a design is well known to those skilled in the art, see in this respect for example patent document US 5,162,771.

The plasma evaporator enhanced by post-magnetron discharge in the plasma furnace presents several advantages:
- 1/ no need for thermally shielded and cooled permanent magnets or electromagnets inside of the plasma furnace, and
- 2/ the power is twice that of a planar magnetron discharge with a crucible of equal area at the same average plasma power density, because both sides of the crucible are heated instead of just one side.

### E. Brief Description of Drawings

Further details and advantages of the invention shall be given in the description below of some specific embodiments of the method and device, according to the invention. This description is only given as an example and does not restrict the scope of the protection claimed; the reference numerals used below pertain to the appended figures.
Figure 1 is a schematic perspective view of a vacuum vessel comprising a vacuum furnace, according to the invention, through which a steel strip to be treated is running.
Figure 2 is the schematic perspective view of the vacuum vessel of Figure 1, wherein lateral components of the vacuum vessel are removed.
Figure 3 is the schematic perspective view of Figures 1 and 2, wherein the vacuum vessel is omitted from the drawing.
Figure 4 is a schematic perspective view of a specific configuration of plasma furnace, according to the invention, comprising a crucible for plasma evaporation of a metal.
Figure 5 is the schematic perspective view of Figure 4 wherein electric insulating shield, the cooled-shield and the thermal shield are removed from the plasma furnace revealing a confinement enclosure onto which the thermal shield is to be secured.
Figure 6 is a schematic perspective view of a central part of the plasma furnace contained in the vacuum vessel of Figures 1 and 2.
Figure 7 is a schematic vertical cross-section of an interesting embodiment of the plasma furnace, according to the invention, containing evaporators composed of a series of stacked crucibles.
Figure 8 is a schematic perspective view of the plasma furnace of Figure 7 in which a lateral part of the vacuum vessel is removed, leaving part of the plasma furnace visible.
Figure 9 is a schematic perspective view of part of the plasma furnace of Figures 7 and 8, comprising an evaporator presenting several crucibles for plasma evaporation of a metal.
Figure 10 is a front perspective view of the part of the plasma furnace of Figure 9 with the structure of permanent magnets removed and showing two anodes which extend along the evaporator.
Figure 11 is a perspective view of the plasma furnace of Figures 8 to 10 with the electric insulating shield, the cooled-shield and the thermal shield removed, such that the anodes, the evaporator and the confinement enclosure of the furnace are visible.
Figure 12 is a schematic perspective view of a front side of a plasma furnace for batch treatment of substrates, according to the invention.
Figure 13 is a schematic perspective view of the back side of the plasma furnace of Figure 12.
Figure 14 is a similar representation of the front side of the plasma furnace of Figure 12 provided with a plasma evaporator and a baffle for communicating with the interior of the vacuum vessel.
Figure 15 is a similar representation of the back side of the plasma furnace of Figure 14 provided with a plasma evaporator and a baffle for communicating with the interior of the vacuum vessel.
Figure 16 is a horizontal cross-section of the plasma furnace represented in Figures 14 and 15.
Figure 17 is a detail of Figure 16 on a larger scale of the back side of the plasma furnace.
Figure 18 is a schematic perspective view of an interesting embodiment of a device, according to the invention, comprising a plasma furnace as represented in Figures 1 to 3 that is laterally connected to evaporators on two opposite sides.
Figure 19 is a schematic representation of a vertical cross-section of the device of Figure 18.
Figure 20 is a schematic perspective view of a plasma furnace of the device represented in Figures 18 and 19, analogous to the plasma furnace represented in Figure 9, shown from the side directed to the central part of the plasma furnace and adapted to the production of compound coatings in the device of Figures 18 and 19.
Figure 21 is a schematic perspective view of the plasma furnace of Figure 20 seen from the side adjacent the evaporator connected to the lateral side as represented in Figures 18 and 19.
Figure 22 is a schematic horizontal cross-section of the part of the plasma furnace represented in Figures 20 and 21.

### F. Detailed description of the invention

The invention concerns in general a method for treatment of a product, in general a substrate, or a sequence of moving products in a plasma heated vacuum furnace and a furnace for applying this method.

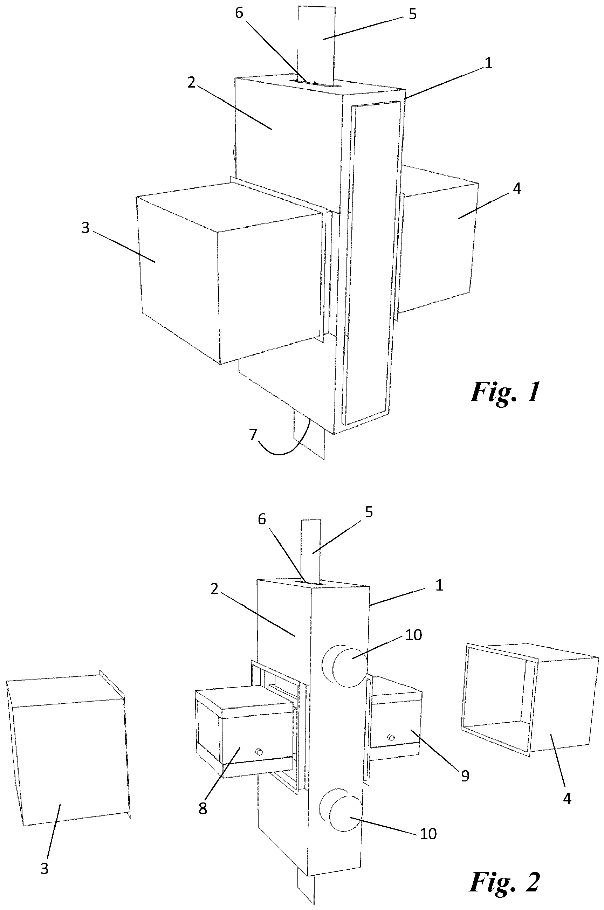

Figures 1 to 6 show several views and parts of a first embodiment of a device according to the invention. The device represented schematically and in perspective in Figure 1, comprises a vacuum vessel 1 presenting a central beam-shaped part 2 having two opposite lateral parts 3 and 4, each of which is more or less cubic. A product to be treated, such as a metal strip 5, is crossing the vacuum vessel 1. The product or metal strip 5 enters the vacuum vessel 1 through an inlet opening 6 and leaves the vessel 1 through an exit opening 7. The inlet and exit openings are provided at opposite sides of the central part 2 of the vacuum vessel 1 such that the product 5 is crossing this part 2 along the longitudinal direction of this central part 2.

In Figure 2 the lateral parts 3 and 4 of the vacuum vessel are removed from the central part 2 to show plasma furnaces 8 and 9 that are contained in these lateral parts 3 and 4 respectively. These plasma furnaces 8 and 9 are thus each connected to a respective opposite side of the central part 2 such that the product 5 to be treated runs between the two plasma furnaces 8 and 9.

The central part 2 of the vacuum vessel 1 has connectors 10 to connect it to a molecular vacuum pump.

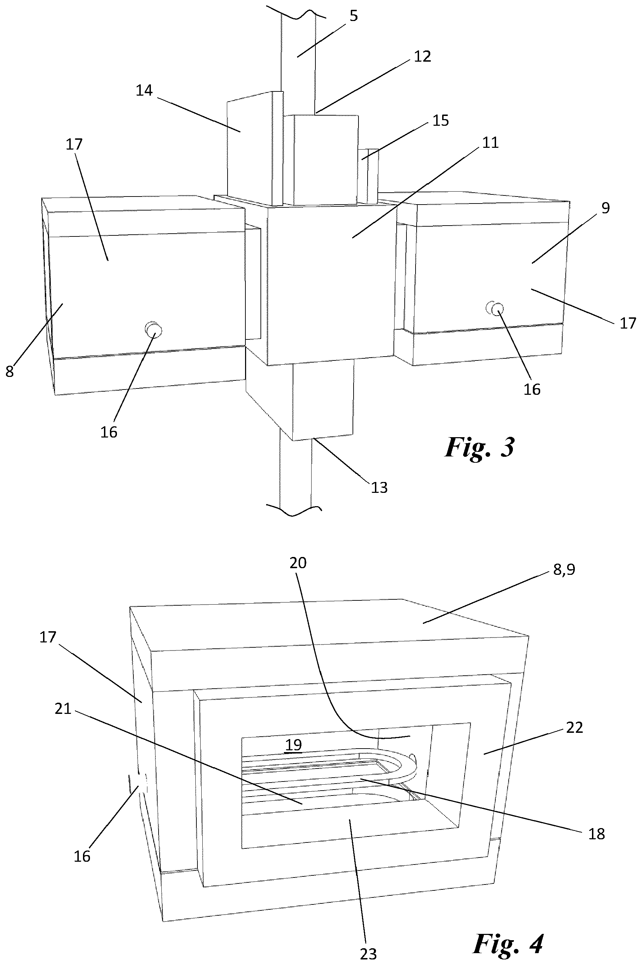

In the representation of the device of Figure 3, the lateral parts 3 and 4 of the vacuum vessel 1 are not represented, nor is the central part 2 of the vacuum vessel 1. This Figure 3 thus shows a plasma furnace comprising said lateral plasma furnaces 8 and 9 and a central furnace 11.

This central furnace 11 is located between the lateral plasma furnaces 8 and 9 to which it connects. The central furnace has an inlet opening 12 and an exit opening 13 for the product or metal strip 5 to be treated. These openings 12 and 13 connect to the respective corresponding inlet opening 6 and exit opening 7 provided in the vacuum vessel 1.

Accordingly, for treatment of the product 5 in the plasma furnace, this product 5 is moved through the inlet openings 6 and 12 into a treatment zone contained in the central furnace 11 where it runs between the two plasma furnaces 8 and 9 that each communicate through a treatment opening with the treatment zone. The product 5 is then moving further trough the respective exit openings 7 and 13.

In this embodiment of the device, according to the invention, the construction of the plasma furnace is modular and includes three main components, i.e. a central furnace 11 and two lateral plasma furnaces 8 and 9. Other configurations with a different number of components are also possible.

Each plasma furnace 8 and 9 communicates with the treatment zone contained in the central furnace 11 through a treatment opening. The plasma furnaces 8 and 9 can be isolated from the central furnace 11 by means of a corresponding thermally shielded door 14 or 15 that is provided to close the respective treatment opening.

In this particular configuration of the invention, the doors 14 and 15 are apparent but these will be preferably integrated inside of the thermally shielded volume of the central furnace 11. Alternatively, the doors 14 and 15 could be placed in the respective plasma furnaces 8 or 9.

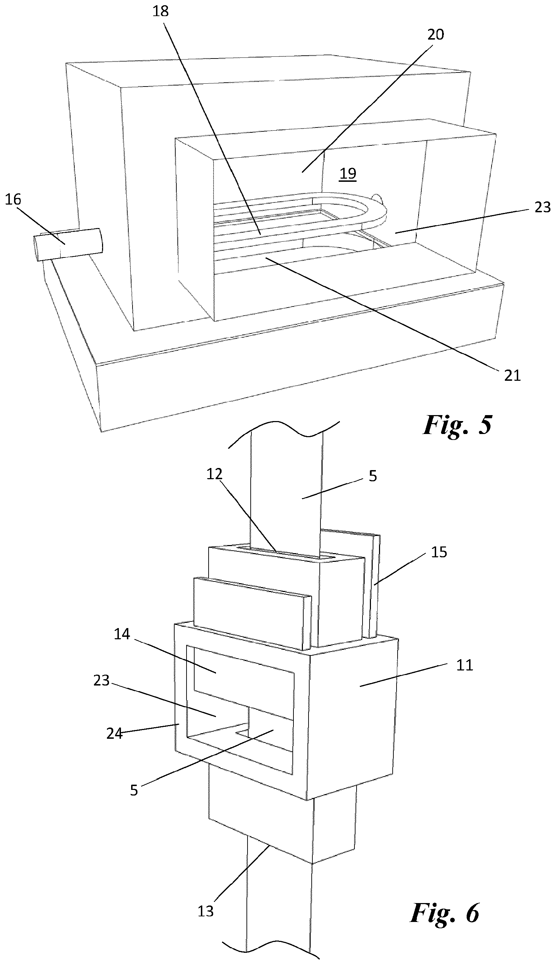

Figure 6 shows in perspective the central furnace 11 with the thermally shielded doors 14 and 15, the product 5 crossing the treatment zone from the inlet opening 12 to the exit opening 13.

Leads 16 cross the walls 17 of the plasma furnace 8 and 9 and are electrically isolated from these walls. These leads 16 connect to an anode 18 present in the internal volume of the plasma furnace 8 and 9 as schematically represented in figure 4.

Starting from the vacuum vessel 1 side towards the internal volume 19 of the plasma furnace 8 and 9, the walls 17 of these plasma furnaces 8 and 9 comprise an electric shield, a cooled-shield, a thermal shield and a surface 20 delimiting the internal volume of the plasma furnace. The electric shield is electrically insulated from the cooled-shield.

Figure 4 presents a specific configuration of a plasma furnace 8 or 9 for plasma evaporation of a material, such as a metal, according to the invention. The overall external surface of the furnace 8,9 is electrically shielded and thermally shielded. In this case, the plasma furnace presents a crucible 21 intended to contain the material that is to be evaporated to treat the product 5 with the vapor thus formed. The anode leads 16 drive current to the anode 18 hovering above the crucible 21 that is maintained at a negative potential against the anode 18 allowing plasma evaporation of the material that is contained in it.

Advantageously, the plasma evaporation is realized by a planar magnetron discharge generated in the vapor of the evaporated material above the crucible 21 by methods well known to those skilled in the art. The anode 18 is also used as counter-electrode to the internal surface 20 of the walls 17. Due to the fact that the internal surface 20 of the walls 17 of the plasma furnace 8 or 9 are generally polarized at a different negative potential than the crucible 21 against the anode 18, the crucible 21 and the walls 17 are electrically insulated from each other. In general, thermal shields and internal surfaces 20 of the three components of the plasma furnace, in particular of the central furnace 11 and of the lateral plasma furnaces 8 and 9, have a common electric potential against the potential of the anode 18.

The plasma furnace 8 or 9 has a flange 22 that surrounds the treatment opening 23 and which is provided to connect to a corresponding flange 24 of the central furnace 11. The latter flange 24 is schematically shown in Figure 6.

In the representation of the plasma furnace 8 or 9 of Figure 5, the electric shield, cooled-shield and thermal shield are removed, thus revealing the outside of the internal surface 20 of the walls 17 of the plasma furnace. The thermal shielding of the walls 17 is secured to the outside of this surface 20. However, this thermal shielding is not shown in Figure 5.

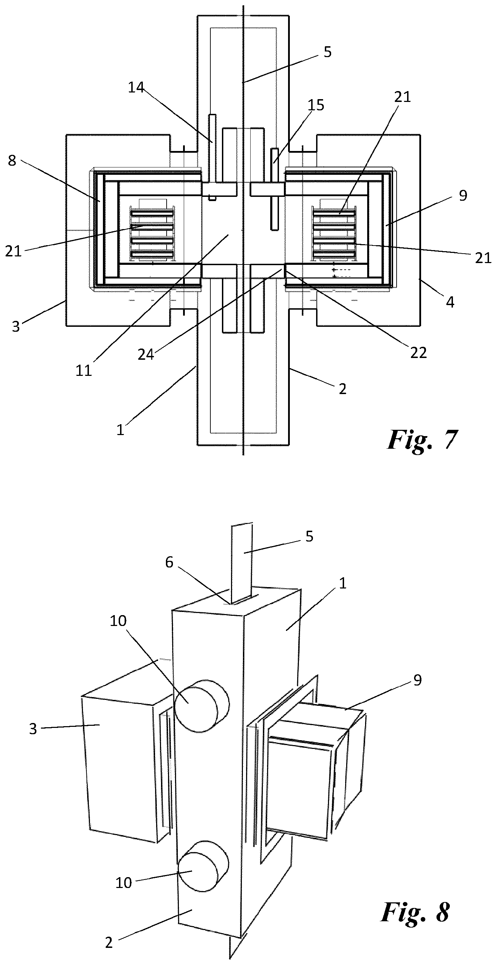

Figures 7 to 11 represent another embodiment of the device according to the invention which is different from the previous embodiment, among other things, in that the plasma furnaces 8 and 9 comprise multiple crucibles 21.

Each of these plasma furnaces 8 and 9 thus constitutes an evaporator presenting a series of stacked crucibles 21. The advantage of using stacked crucibles 21 instead of a single crucible is the ability to accommodate a significantly larger amount of the material to be vaporised in the volume of the plasma furnace compared to what is possible when using only a single crucible.

Figure 7 illustrates a cross-sectional view of a device, according to the invention, in which a product in the form of a continuous metal strip 5 is treated. The device has two lateral plasma furnaces 8 and 9 each presenting four crucibles 21 that are placed one above the other.

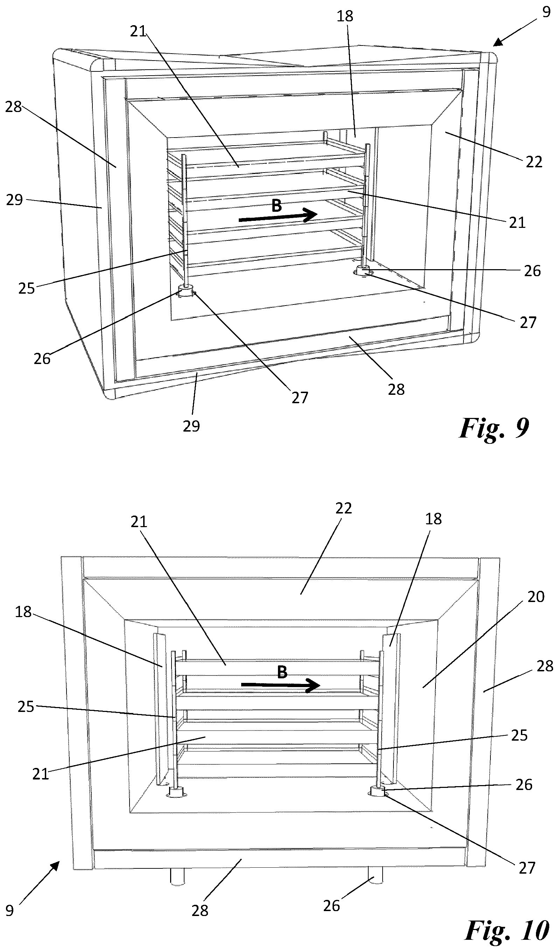

In the schematic drawing of Figure 8 the lateral part 4 of the vacuum vessel 1 enveloping the lateral plasma furnace 9 is removed, thus leaving visible the outside of lateral plasma furnace 9. The latter is also shown in Figure 9 without the vacuum vessel 1, the central furnace 11 and the opposite lateral plasma furnace 8.

As already described, the lateral furnaces 8 and 9 have a flange 22 that surrounds the treatment opening 23 and that is provided to be tightly coupled to the corresponding flange 24 of the central furnace 11 in order to avoid any gas leak between the lateral furnaces 8 or 9 and the central furnace 11.

In this specific arrangement represented in Figures 7 to 11, the stack of crucibles 21 of each lateral furnace 8 and 9 thus constitutes an evaporator each having four crucibles 21 containing the material to be evaporated. The number of crucibles 21 can range from 1 to any integer, depending on the working conditions. These crucibles 21 are supported by a frame 25 presenting supporting feet 26 that cross corresponding openings 27 provided in the bottom wall of the plasma furnace 8 or 9. These feet 26 thus also crosse the thermal shielding 28 and magnetic circuit 29 as schematically represented in Figure 9.

The crucibles 21 and the frame 25 are electrically isolated from the internal surface 20 of the plasma furnaces 8 and 9 and from the corresponding anodes 18. The thermal shielding 28 that is adjacent to the internal surface 20, is made of an insulating thermal shielding material. Such a shielding material is preferably composed of a stack of molybdenum foils in an arrangement well known to those skilled in the art. On this stack of molybdenum foils is, for example, secured a cooled-shield, that is preferably water-cooled. The external surface of this cooled-shield is covered, at less than 5 mm of distance, by an electrically isolated shield, not shown, onto which are secured the permanent magnets and yokes composing the magnetic circuit 29.

The structure of the magnetic circuit 29 is, for example, a Halbach array with cladded magnets which produces an axial field of magnetic induction B, oriented as shown by the arrow B in Figure 9, within the volume enclosed by the structure of permanent magnets. Outside of this volume, a significantly lower magnetic induction field is generated. Such a magnetic structure is similar to the one that is described in patent document US 5,162,771 and such a design is well known to those skilled in the art.

Advantageously, the field of magnetic induction is oriented such as to be substantially parallel to the surface and parallel to the longest axis of the crucibles 21. This leads to the generation of a post magnetron discharge around each crucible 21 allowing twice the power to be delivered compared to a planar magnetron discharge with a crucible of equal area at the same average plasma power density, because both sides of the crucible are heated instead of only one side.

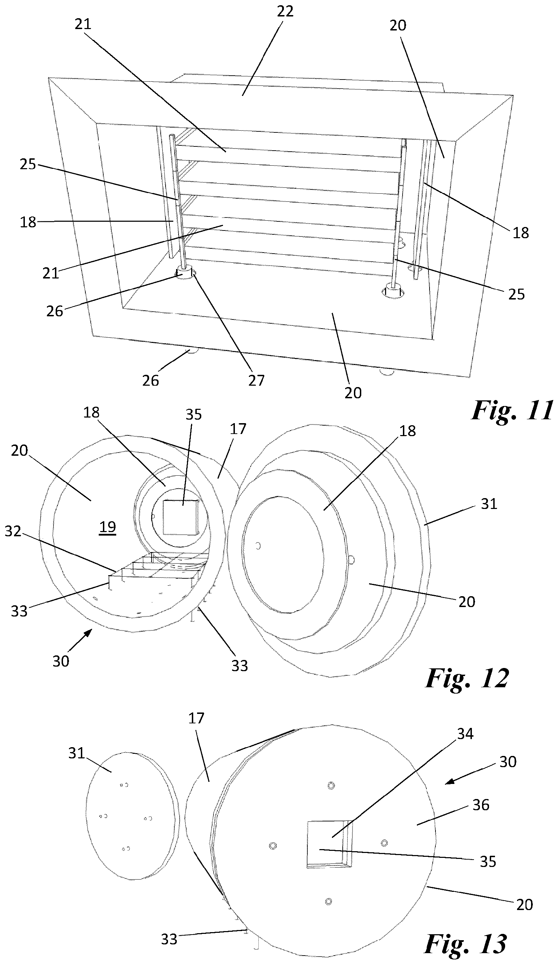

In the representation of the plasma furnace 9 in Figure 10, the magnetic circuit 29 with the structure of permanent magnets is removed, while in Figure 11 the thermal shielding 28 has been additionally removed. Accordingly, Figure 11 shows the electrically conductive internal surface 20 of plasma furnace 9 that connects to the flange 22 and that contains the anodes 18 positioned on opposite sides of the crucibles 21.

Figures 12 and 13 concern another embodiment of the invention that comprises a plasma furnace 30 intended to be used for treatment of a product or several products in a batch process. This plasma furnace 30 has a cylindrical shape and should be contained in a high-vacuum vessel. For clarity, this vacuum vessel is not represented in the Figures.

The plasma furnace 30 has a door 31 allowing to close the internal volume 19 of the plasma furnace 30 and seal it from the free space in the vacuum vessel enveloping the plasma furnace 30.

The plasma furnace 30 and its closing door 31 present the same wall structure as described above, i.e. an electric conductive internal surface 20 that delimits the internal volume 19, covered by a thermal shielding 28 and a cooled shield. The cooled shield is protected on its external surface by an electrically isolated shield.

As already indicated above, the goal of the electric isolated shield is to prevent the creation of any parasitic plasma in the free space between the plasma furnace 30 and the internal side of the walls of the vacuum vessel that is not represented in the figures. The vacuum vessel is generally maintained at grounded potential.

The plasma furnace 30 as shown in Figures 12 and 13 has two annular anodes 18 in the internal volume 19. These anodes 18 extend parallel to each other on opposite sides of the plasma furnace 30. One of the anodes 18 is fixed to the inside of the door 31. A supporting table 32 for the products to be treated is provided between the anodes 18 in the plasma furnace 30.

The internal surface 20 that is electric conductive, constitutes a confinement enclosure for the internal volume 19 of the plasma furnace 30. The internal surface 20 and the adjacent walls 17 of the plasma furnace 30 are at the same electric potential which is negative against the potential of the anodes 18.

The load, i.e. the product or substrate 5 to be treated in the plasma furnace 30, must be placed onto the supporting table 32 that can be polarized against the potential of the anodes 18. Hence, the supporting table 32 is supported by feet 33 that cross the thermal and electric shielding of the plasma furnace 30 and that are electrically isolated from these feet 33.

The internal volume 19 of the plasma furnace 30 is vacuum pumped through an aperture 34 present in the rear side 36 of the plasma furnace 30. This rear side 36 of the plasma furnace 30 is the side opposite to the side presenting said door 31. The aperture 34 is protected by a thermal shield 35 that is extending in front of the aperture 34 at a small distance from the internal surface 20 of rear side 36 that is sufficient for vacuum pumping the internal volume 19.

The thermal shield 35 and the internal surface 20 of the plasma furnace 30, comprising the internal surface of the door 31, have the same electric potential and are thermally shielded and electrically isolated in the same way as described above.

An equipment, not shown, could be secured onto the external walls of the plasma furnace 30 for creating a magnetic induction field in the internal volume 19 of the plasma furnace 30 following its axis, i.e. along the axis of the cylinder defined by the shape of the furnace 30.

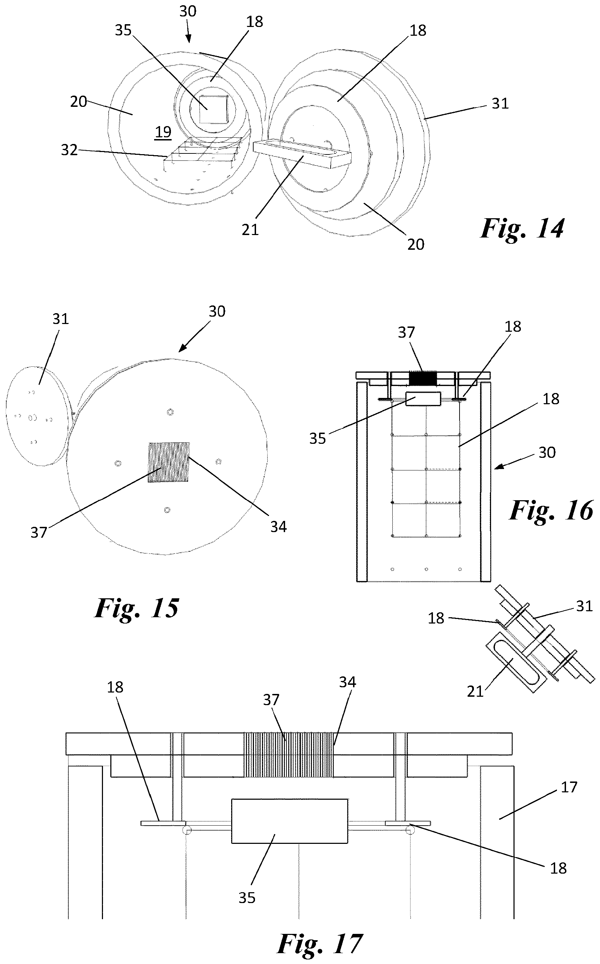

The plasma furnace 30 represented in Figures 14, 15, 16 and 17 is similar to the furnace shown in Figures 12 and 13, but is additionally provided with a plasma evaporator comprising a crucible 21 and a baffle 37. The baffle 37, for example, is composed of side-by-side parallel slats and is placed in the aperture 34 and fills it substantially completely. The slats extend preferably substantially transversal to the wall presenting the aperture 34.

The baffle 37 is preferably water-cooled and aims:
- i) to decay the plasma density that prevails in the internal volume 19 of the plasma furnace 30 toward the internal walls of the vacuum vessel (not shown) and
- ii) to condense on it the evaporated material from the crucible 21 to prevent any contamination of the internal walls of the vacuum vessel that contains the plasma furnace 30.

In an interesting embodiment of the plasma furnace 30, according to the invention, an equipment, not shown, can be secured onto the external walls of the plasma furnace 30, for generating a magnetic induction field in the internal volume 19 of the plasma furnace following its axis, i.e. along the axis of the cylinder defined by the shape of the furnace 30.

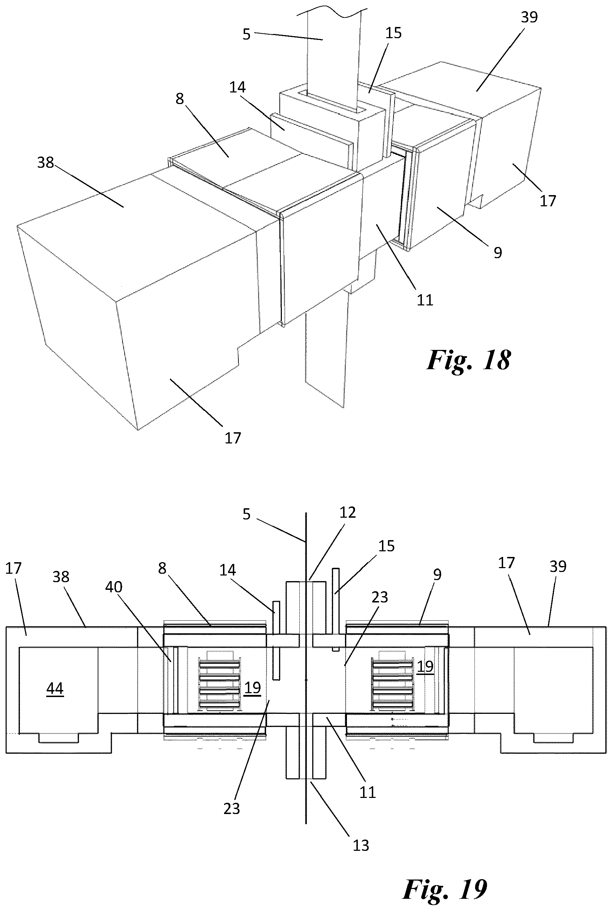

Figures 18 to 22 show an equipment, according to the invention, for continuous coating of a product 5, formed by a continuous strip, by a compound of two elements. The vacuum vessel that contains this equipment is not represented in the drawings.

This equipment is similar to the device represented in Figures 7 and 8. In particular, the central furnace 11 of both embodiments of the invention, is similar, while the lateral plasma furnaces 8 and 9 each connect to a respective evaporator assembly 38 and 39.

The lateral plasma furnaces 8 and 9 each comprise a stack of crucibles 21 as already described in relation to the embodiment of the invention represented in Figures 7 to 11

The side of each of the plasma furnaces 8 and 9 opposite said treatment opening 23 and opposite said central furnace 11 has an opening 40 that communicates with the respective evaporator assembly 38 or 39. Such an evaporator assembly 38 or 39 comprises a closed volume that is surrounded by walls 17 forming a thermal shield and in which is provided a crucible 21 for the material to be evaporated.

Said two elements that are to be deposited onto the product 5 as a compound of these two elements are thus evaporated respectively in the evaporator contained in the plasma furnaces 8 and 9 and in the evaporator assemblies 38 and 39.

The element evaporated in the evaporator assemblies 38 and 39 is flowing through said opening 40 to the respective plasma furnace 8 or 9. The evaporator assemblies 38 and 39 work necessarily at a lower temperature than the temperature prevailing in the plasma furnaces 8 and 9 with the objective to prevent any condensation of the element evaporated in the evaporator assemblies 38 and 39 onto the internal surface 20 of the plasma furnaces 8 and 9.

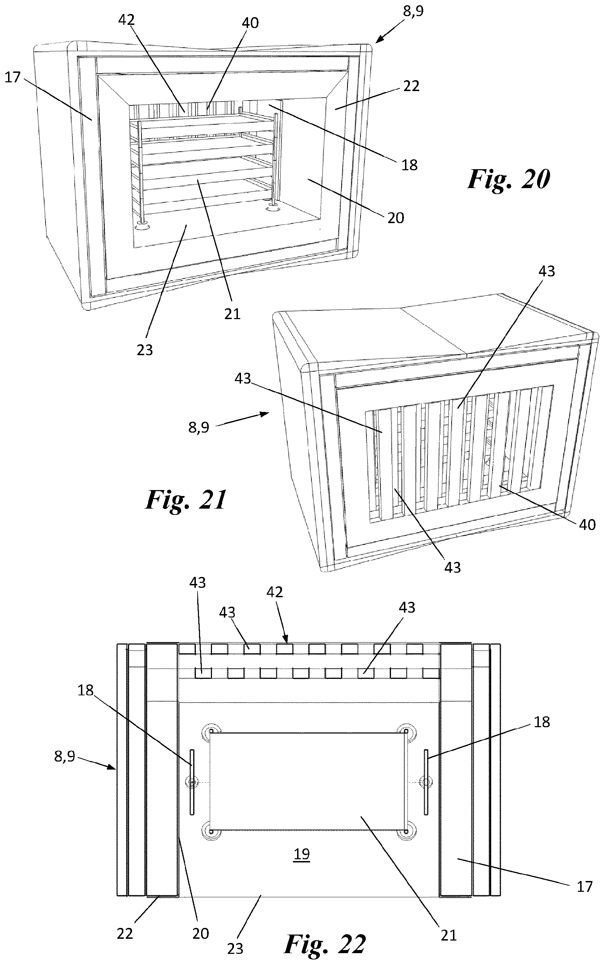

In the opening 40 through which the plasma furnaces 8 and 9 are connected to the respective adjacent evaporator assembly 38 or 39, a baffle 42 is present. As is illustrated clearly in Figures 21 and 22, this baffle 42 comprises two parallel rows of parallel slats 43, whereby the slats 43 of these rows are staggered in relation to each other. Thus the baffle 42 optically shields the internal volume 19 from the plasma furnace 8 or 9 from the internal volume 44 of the respective adjacent evaporator assembly 38 or 39. Accordingly, the baffle 42 is obstructing the exchange of radiation, while allowing the passage of vapor from the evaporator assembly 38 or 39 towards the plasma furnace 8 or 9.

Thus the vapor of the evaporated material contained in the crucible 21 present in the evaporator assemblies 38 and 39 can flow through the concerned baffle 42 towards the adjacent plasma furnace 8 or 9. This baffle 42 forms a thermal shield that is reducing significantly the thermal radiation exchange between the plasma furnace and the adjacent evaporator assembly.

Further, the presence of the baffle 42, in combination with the flow of vapor of the evaporated material from the evaporator assembly 38 or 39 towards the plasma furnace 8 or 9, minimizes the vapor backflow from the plasma furnace 8 or 9 towards the evaporator assembly 38 or 39 of the material evaporated in the plasma furnace 8 or 9.

Advantageously, the plasma furnace 8 or 9 comprises a stack of crucibles 21 to allow applying a coating onto the product 5 without requiring continuous feeding of the material contained in these crucibles 21.

The crucible 21 contained in the evaporator assembly 38 and 39 is preferably continuously fed by the element being evaporated, for example by feeding the element in liquid form, as may be the case for zinc.

### G. Operating steps in some examples of particular configurations of the invention

### G.1. Operating steps for processing plants in which products are transported relatively to the plasma furnace.

Continuous coating of steel products, such as for example a steel strip, can be realized in a coater as shown in Figures 1 to 3, Figures 6 to 8 or Figures 18 and 19 . The coater components represented in these figures are adapted to coating of steel strip by plasma evaporation but the principles given below, illustrated for a flat product, are quite general and it will be obvious to those skilled in the art to adapt them to any kind of products such as wires, cords, plates, beams, items or foils of any material in particular those flat products, such as metallic or non-metallic foils, that have to be supported onto a cooling drum for purpose of cooling during coating when the plasma furnace flange 22 closely faces the flat product 5 supported onto said cooling drum. This specific arrangement wherein the product is supported by a cooling drum, as many other possible configurations of the invention, is not shown in the figures.

Once the working pressure, generally high vacuum, has been reached in the coating plant including the internal volume 19 of the plasma furnaces 8,9 and of the central furnace 11, the first step is to bring the plasma furnace 8 and 9 to its working temperature. In order to achieve that goal, the product 5 is thermally shielded from the internal volume 19 of the plasma furnaces 8 and 9 by closing the doors 14 and 15.

It is important to note that the device, according to the invention, can also be designed in a horizontal configuration. In such an embodiment, it can be used for coating products passing through it one behind the other such as, for example steel long products. In such a case, the doors 14 and 15 are advantageously placed at the entry and exit openings 12 an 13 for the products 5. The number of plasma furnaces 8 or 9 and doors 14 and 15 is not limited to two as shown in the figures but could vary from 1 to more than 2 depending on the application.

Once the plasma furnaces 8 and 9, containing the plasma evaporator, have been isolated from the substrate 5 and from the rest of the plant by the doors 14 and 15, a rare gas, preferably argon, is introduced into the internal volume 19 of the plasma furnace 8 and 9 to reach a pressure typically in the 0.01-0.1 mbar range.

Note, in this respect, that the pressure range allows to limit the erosion of the internal surface 20 of the walls 17 of plasma furnaces 8 or 9 by sputtering during plasma discharge when argon (Ar) is used. When helium (He) is used the pressure can be lowered below 0.01 mbar without risk of significant sputtering of the internal surface 20.

Next, the internal surface 20 of the plasma furnaces 8 and 9 and the crucible(s) 21 are polarized at their respective negative potentials against the anode potential of anode 18. Power transfer by the plasma at the internal surfaces 20 of the plasma furnaces 8 and 9 is regulated respectively by the power supply connected to internal surface 20 and by the power supply connected to the crucible(s) 21 in order to reach, at those surfaces, a temperature as close as possible to the temperature needed for plasma evaporation of the material contained in the crucible(s). At such temperature, the doors 14 and 15 are opened and at the same time the power delivered to the internal surfaces 20 of the plasma furnaces 8 and 9 is raised with the remaining amount needed to achieve the requested temperature which corresponds to the working plasma evaporation rate. When that temperature is reached, the rare gas supply is cut off, the plasma discharge being then only sustained in the vapor of the element that is evaporated in the plasma furnaces 8 and 9. If a bias voltage is needed between the product 5 and the plasma during coating, it is applied by maintaining a controlled difference of potential, pulsed or not, between the anode 18 and the product 5. The product 5 to be treated is preferably at ground potential for continuous coating processes such as for coating a continuous steel strip. However, when products 5 are to be coated one behind the other, as for example, in the case of coating of long steel products transported on a bank of supporting rollers, it is not required to keep these discrete products 5 at ground potential. Indeed, in such case, the products 5 isolated from the workers by the grounded vacuum vessel can be safely maintained at a negative potential against the ground.

At the end of the process, when the plasma power supplies are off, the plasma furnaces 8 and 9 must be cooled before venting. The cooling is advantageously accelerated by introducing a rare gas, preferably argon, in the plant at a pressure between 1 and 10 mbar. When the temperature of the walls 17, i.e. of the internal surface 20, of the plasma furnaces is lower than 100°C, venting can generally be operated.

### G.2 Operating steps for processing plants in which products are treated as stationary batches inside of the plasma furnace.

Products that are processed in batch use plasma furnaces of the kinds shown in Fig.12-17.

In such processing plants, the operating steps are as follows, starting with the plant at room temperature:
- Loading the product 5 to be processed onto the supporting table 32
- Vacuum pumping of the vacuum furnace 30 to a base pressure lower than 10⁻⁴ mbar
- In the case of product brazing or annealing, with rare gas introduced for working at pressure in the range 0.01 - 0.1 mbar, polarize negatively the internal surface 20 of the walls of the vacuum furnace 30 and the product 5 against the anode 18 following the program of temperature evolution determined by the brazing alloy. Controlled cooling by cutting off plasma power supplies and increasing rare gas pressure in the 1-10 mbar range. Standard gas quenching is generally applied, by methods well known to those skilled in the art, at the end of brazing before venting.
- In the case of product coating by plasma evaporation, the steps are as follows:
   - i) sputter etching of the product 5, at argon pressure set in the 0.001 - 0.1 mbar range, by applying a negative potential between the table, rack or barrel 32 supporting the product 5 and the anode 18, the time necessary to reach the etching dose;
   - ii) rapid heating of the internal surface 20 of the walls of the plasma furnace 30 and of the crucible 21 to reach a temperature close to the temperature for plasma evaporation. That is achieved by controlled plasma heating of the internal surface 20 of the walls of the plasma furnace 30 and controlled plasma heating of the crucible 21 in rare gas at pressure comprised between 0.01 and 0.1 mbar to avoid sputtering of the walls (note that in helium, the pressure can be lower than 0.01 mbar as already mentioned above). As previously described, the internal surface 20 of the walls of the plasma furnace 30 and of the crucible 21 are negatively polarized at their respective potentials against the potential of the anode 18;
   - iii) coating of the product 5 by plasma evaporation by increasing the power at the internal surface 20 of the plasma furnace 30 and at the crucible 21 to the requested level while cutting off the supply of rare gas. A negative bias is possibly applied between the product 5 and the plasma by polarizing negatively the table 32 supporting the product 5 against the anode 18.
   - iv) system cooling after coating by turning off all plasma power supplies and increasing the pressure of the rare gas to the 1-10 mbar range. When the temperature of the internal surface 20 of the walls of the vacuum furnace 30 is lower than 100°C, the system is vented and the product unloaded. The rapid heating of the thermal shielding of the plasma furnace 30 and the rapid heating of the crucible 21 allows to keep the product temperature low enough to be coated by the material evaporated from the crucible 21 because of the limited energy transfer to the product 5 by radiation. The contamination of the vacuum vessel internal walls is prevented by the cooled baffle 37 protecting the vacuum pumping port of the vessel. It is noticeable that during the step of rapid heating of the internal surface 20 of the plasma furnace 30, the sputtered material (in most case iron from etched steel product) deposited on this internal surface 20 will be evaporated and transported by the rare gas to be finally mainly condensed onto the surface of the cooled baffle 37. Hence, the system is self-cleaning. The baffle 37 is cleaned from condensed materials during maintenance periods.

### H. Examples of applications

### H.1. Copper coating on a steel strip by plasma evaporation

A steel strip coater, according to the invention, working under high-vacuum is equipped with one plasma evaporation unit secured in the vacuum vessel of the type shown in Figures 1 to 5. Two plasma furnaces 8 and 9 are provided, one per side of the strip, the strip running continuously through the central plasma furnace 11 from an inlet opening 12 to an exit opening 13 as illustrated in Figure 3. The plasma furnaces 8 and 9 are tightly bounded by their corresponding flanges 22 in order to confine the metal vapor inside of the heated volume 19 of the plasma furnaces 8 and 9 and to minimize the metal vapor losses at the entry and exit openings. The discharge at the crucible 21 is magnetically enhanced to form a planar magnetron discharge in an equipment making use of the principles as disclosed in Figures 4 and 5. The system is preheated at a temperature of 1300°C following the procedure described in section G.1 actuating the thermally shielded doors 14 and 15 that are fully opened during coating. The temperature in the plasma furnaces 8 and 9 is raised to 1500°C during coating. The crucible 21 containing the molten copper is continuously fed by solid copper bars or wire molten by plasma heating inside of the plasma furnace. Upstream to the plasma evaporation, a plasma etching unit is provided to sputter etch the surface of the strip from any carbon and oxide contamination to enhance the adhesion between the steel surface and the copper coating.

The copper coating produced by plasma evaporation under the following conditions corresponds to the (111) textured electroplated copper coating typically used in automotive and electrical applications:
- Steel strip width: 1000 mm
- Steel strip thickness: 1 mm
- Line speed: 1 m/s
- Coating thickness: 1 µm per side
- Evaporation power: 55 kW per plasma evaporator
- Bias voltage power: 81 kW
- Plasma furnace heating power: 20 kW per plasma furnace
- Copper consumption: 32 kg/hour per evaporator
- Temperature increases of the strip due to coating: < 50°C

### H.2. Aluminum coating on steel strip by plasma evaporation

A steel strip coater working under high-vacuum is equipped with two coating units, according to the invention, connected in series and secured each in their vacuum vessel 1 of the type shown Figure 1 and Figure 8. Two lateral plasma furnace 8 and 9 are provided in each coating unit, one per side of the strip, the strip 5 running continuously through the central plasma furnace 11 from an inlet opening 12 to an exit opening 13 as illustrated in Figure 7. Only one crucible 21 is provided per plasma furnace 8 and 9.

The discharge in the lateral plasma furnaces 8 and 9 is magnetically enhanced to form a post cathode magnetron discharge by the induction field as illustrated in Figure 9. The system is preheated at a temperature of 1200°C following the procedure described in section G.1 actuating the thermally shielded doors 14 and 15 that are fully opened during coating. The plasma furnace temperature is raised to 1420°C during coating. The crucible 21 containing the molten aluminum is continuously fed with molten aluminum at a temperature close to 660°C. Upstream to the plasma evaporation, a plasma etching unit is provided to sputter etch the surface of the strip from any carbon and oxide contamination to enhance the adhesion between the steel surface and the aluminum coating. Voltage biasing is applied between the grounded strip 5 and the anode 18 to reach Ion Vapor Deposition (IVD) quality typically requested for aeronautical applications.

### Typical working conditions:

- Steel strip width: 1250 mm
- Steel strip thickness: 2 mm
- Line speed: 1 m/s
- Coating thickness: 10 µm per side
- Evaporation power: 245 kW per plasma evaporator
- Bias voltage power: 85 kW per coating unit
- Plasma furnace heating power: 20 kW per plasma furnace
- Aluminum consumption: 61 kg/hour per plasma evaporator
- Temperature increases of the strip due to coating: < 150°C

### H.3. BNi-2 brazing of AISI 321 steel parts in batch

Parts to be brazed are treated in batch in a plasma furnace as shown Figure 12 and 13, following the method described in section G.2. For a plasma furnace volume of 3.5 m³ with an internal area totalizing 13 m², typical working conditions are as follows:
- Loading of parts on table 32
- Vacuum pumping of the system to a base pressure lower than 10⁻⁴ mbar
- Argon inlet to reach a pressure of 0.05 mbar
- Preheat - Room temperature to 850°C in 50 min
   ∘ Plasma heating of the internal surfaces of the plasma furnace by negative voltage biasing of the internal surfaces 20 against anode 18
   ∘ Plasma heating of 1 metric ton of parts by negative voltage biasing of table 32 against anode 18
- Dwell time at 850°C for 30 min
   ∘ Plasma heating of the internal surface 20 of the walls of the plasma furnace 30 by negative voltage biasing of the surface 20 against anode 18
- Heating from 850°C to 1100°C in 30 min
   ∘ Plasma heating of the internal surface 20 of the walls of the plasma furnace 30 by negative voltage biasing of this surface 20 against anode 18
   ∘ Plasma heating of 1 metric ton of parts by negative voltage biasing of table 32 against anode 18
- Brazing time at 1100°C for 25 min
   ∘ Plasma heating of the internal surface 20 of the walls of the plasma furnace 30 by negative voltage biasing of the surface 20 against anode 18
- Slow cooling for 40 min
   ∘ All plasma power supplies switched off
   ∘ Argon supply closed
- Quenching under argon and venting when furnace internal wall temperature and part temperature is lower than 100°C

### H.4. Aluminum coating on steel parts in batch

Aluminum coating on steel alloy parts as substitute of cadmium coating, mainly used for aeronautical and military applications, is currently realized by Ion Vapor Deposition (IVD). IVD is basically a high-vacuum evaporation process that presents the drawbacks of significant losses of aluminum to the walls of the vacuum vessel and relatively high thermal losses. One specific configuration of the invention provides an answer to these drawbacks.

For this application, the configuration of the equipment as shown in Figures 14 to 17 is used with a procedure similar to that described in section G.2. The basic idea is to heat up the internal surface 20 of the walls 17 of the plasma furnace 30 and raise the temperature of the internal surface 20 much faster than the parts 5 to be coated. For a plasma furnace of 1 m³ and 6 m² of area of internal walls of the plasma furnace, targeting products 5 of specific area lower than 25 m² per ton and setting the heating time to working temperature at 6 minutes, the working conditions for a product load of 160 kg are as follows:
- Loading of parts onto supporting equipment 32
- Vacuum pumping of the system to a base pressure lower than 10⁻⁴ mbar
- Argon inlet to reach a pressure of 0.005 mbar
- Sputter cleaning of parts by negative polarization of the support 32, hence the product against the anode potential (typically between 100 and 1500 V with 20 kW of installed power)
- Plasma furnace heating to 1267°C in 6 min
   ∘ Argon inlet to a pressure of 0.05 mbar
   ∘ Plasma heating of the internal walls of the plasma furnace by negative voltage biasing of the internal surface 20 of the plasma furnace 30 against anode 18 (installed power 200 kW)
- Plasma evaporation for 10µm thick aluminum coating
   ∘ Installed power: 100 kW
   ∘ Coating time: < 1 min
- Product temperature increase: < 180°C

### H.5. Chromium coating on steel parts in batch

The system configuration and geometry are the same as in section H.4 and the working procedure is identical with the same characteristics of the load to be coated. For a chromium coating of 1 µm in thickness, the typical working conditions are the followings:
- Loading of parts onto supporting equipment 32
- Vacuum pumping of the system to a base pressure lower than 10⁻⁴ mbar
- Argon inlet to reach a pressure of 0.005 mbar
- Sputter cleaning of parts by negative polarization of the support 32, hence the product against the anode potential (typically between 100 and 1500 V with 20 kW of installed power
- Plasma furnace heating to 1537°C in 6 min
   ∘ Argon inlet to a pressure of 0.05 mbar
   ∘ Plasma heating of the internal surface of the walls of the plasma furnace by negative voltage biasing of this surface against anode 18 (installed power: 300 kW)
- Plasma evaporation for 1 µm thick chromium coating
   ∘ Installed power: 60 kW
   ∘ Coating time: < 30 s
- Product temperature increase: < 280°C

### H.6. Zn5%Al coating of steel strip by plasma evaporation

This product is similar to GALFAN, i.e.: ZA095 (95 g/m² / 7µm per side).

A steel strip coater working under high-vacuum is equipped with one coating unit as shown Figure 18. The evaporator assembly 38 or 39 allows plasma evaporation of zinc and the plasma furnace 8 or 9 is equipped with one crucible 21 for the evaporation of aluminum. The strip 5 runs continuously through the central plasma furnace 11 from an entry opening 12 to an exit opening 13. The plasma furnaces 8 and 9 are tightly bounded by their corresponding flanges 22 in order to confine the metal vapor inside of the heated internal volume 19 and to minimize the metal vapor losses at the entry and exit openings. The internal surface 20 of the walls 17 of the lateral plasma furnaces 8 and 9 and the crucibles 21 are preheated at a temperature about 200°C lower than the nominal temperature for evaporation of aluminum following the procedure described in section H.2 actuating the thermally shielded doors 14 and 15 that are fully opened during coating. During coating, the temperature of the surface of the walls of the plasma furnaces 8 and 9 and have been raised to the nominal temperature of evaporation of aluminum and the flow of argon has been stopped. The surfaces of the walls of the plasma furnaces 8 and 9 and of the evaporator assemblies 38 and 39 for vaporizing zinc have been brought to the nominal temperature for the evaporation of zinc with a similar procedure as described in section G.1.

### Typical working conditions:

- Steel strip width: 1500 mm
- Steel strip thickness: 1 mm
- Line speed: 2 m/s
- Coating thickness: 7 µm per side
- Zinc evaporation power: 625 kW per plasma evaporator
- Zinc consumption: 947 kg/hour per evaporator
- Zinc plasma furnace heating power: 7 kW per plasma furnace
- Aluminum evaporation power: 247 kW per plasma evaporator
- Aluminum consumption: 50 kg/hour per evaporator
- Aluminum plasma furnace heating power: < 100 kW per plasma furnace
- Temperature increases of the strip due to coating: < 61°C

### H.7. Al9%Si coating on steel strip by plasma evaporation

This product is similar to aluminized steel T1-13 (type 1, 40 g/m²).

A steel strip coater working under high-vacuum is equipped with one coating unit as shown Figure 18. The evaporator assembly 38 and 39 allows plasma evaporation of aluminum and the plasma furnace 8 and 9 is equipped with one crucible 21 for the evaporation of silicon. The strip 5 runs continuously through the central plasma furnace 11 from an entry opening 12 to an exit opening 13. The plasma furnaces 8 and 9 are tightly bounded by their corresponding flanges 22 to the central furnace 11 in order to confine the metal vapor inside of the heated volume and to minimize the metal vapor losses at the entry and exit openings. The surface 20 of the walls of the plasma furnaces 8 and 9 and crucibles 21 are preheated at a temperature about 200°C lower than the nominal temperature for evaporation of silicon following the procedure described in section G.1 actuating the thermally shielded doors 14 and 15 that are fully opened during coating. During coating, the temperature of the surface 20 of the walls 17 of the plasma furnaces 8 and 9 and of the crucibles 21 have been raised to the nominal temperature of evaporation of silicon and the flow of argon has been stopped. The surface 20 of the walls 17 of the lateral plasma furnaces 8 and 9 and the crucibles 21 of the evaporator assemblies 38 and 39 have been brought to the nominal temperature for evaporation of aluminum following the procedure described in section H.2.

### Typical working conditions:

- Steel strip width: 1500 mm
- Steel strip thickness: 1 mm
- Line speed: 2 m/s
- Coating thickness: 6.35 µm per side
- Aluminum evaporation power: 1389 kW per plasma evaporator
- Aluminum consumption: 332 kg/hour per evaporator
- Aluminum plasma furnace heating power: 45 kW per plasma furnace
- Silicon evaporation power: 972 kW per plasma evaporator
- Silicon consumption: 33 kg/hour per evaporator
- Silicon plasma furnace heating power: < 93 kW per plasma furnace
- Temperature increases of the strip due to coating: < 177°C

### H.8. Zn10%Ti coating on steel strip by plasma evaporation

This concerns a new product that is showing a time to red rust during salt spray test that is 4 times longer than the time to red rust obtained with the same test for a zinc coating of equivalent thickness.

A steel strip coater working under high-vacuum is equipped with one coating unit as shown Figure 18. The evaporator assembly 38 and 39 allows plasma evaporation of zinc and the plasma furnace 8 and 9 is equipped with one crucible 21 for the evaporation of titanium. The strip 5 runs continuously through the central plasma furnace 11 from an entry opening 12 to an exit opening 13. The internal surfaces 20 of the walls 17 of the plasmas furnaces 8 and 9 and the crucibles 21 are preheated at a temperature about 200°C lower than the nominal temperature for evaporation of titanium following the procedure described in section G.1 actuating the thermally shielded doors 14 and 15 that are fully opened during coating. During coating, the temperature of the surfaces 20 of the walls of the plasma furnaces and of the crucibles 21 have been raised to the nominal temperature of evaporation of titanium and the flow of argon has been stopped. The internal surface 20 of the walls 17 of the plasma furnaces and the crucibles 21 of the zinc evaporator assemblies 38 and 39 have been brought to the nominal temperature for the evaporation of zinc with a similar procedure as described in section G.1.

### Typical working conditions:

- Steel strip width: 1500 mm
- Steel strip thickness: 1 mm
- Line speed: 2 m/s
- Coating thickness: 4 µm per side
- Zinc evaporation power: 346 kW per plasma evaporator
- Zinc consumption: 524 kg/hour per evaporator
- Zinc plasma furnace heating power: 7 kW per plasma furnace
- Titanium evaporation power: 552 kW per plasma evaporator
- Titanium consumption: 58 kg/hour per evaporator
- Titanium plasma furnace heating power: < 61 kW per plasma furnace
- Temperature increases of the strip due to coating: < 69°C

### H.9. Zn3%Cr coating on rebars by plasma evaporation

This is a new product that has a time to red rust during salt spray test that is 6 times longer than the time to red rust obtained with the same test for a zinc coating of equivalent thickness. The typical zinc coating thickness produced by continuous galvanizing of rebars is 50 µm.

A rebar coater working under high-vacuum and designed to treat 20 rebars in parallel is equipped with one coating unit comprising one plasma furnace 8 and 9 containing one crucible 21 for chromium connected to one zinc evaporator assembly 38 and 39, similarly as shown in Figure 18. Contrarily to Figure 18, the rebars are transported horizontally. Each coating unit is secured at the opposite side of the central plasma furnace 11 working at the nominal temperature for chromium evaporation. The central furnace 11 is equipped with a vapor distributor allowing even coating thickness distribution on the rebars that cross the coating zone. The rebars run continuously through the central plasma furnace 11 from an entry opening 12 to an exit opening 13. The internal surface 20 of the walls 17 of the plasma furnace 8 and 9 and crucibles 21 are preheated at a temperature about 200°C lower than the nominal temperature for evaporation of chromium following the procedure described in section G.1 actuating the thermally shielded doors 14 and 15 that are fully opened during coating. During coating, the temperature of the internal surface of the walls of the plasma furnaces and of the crucibles have been raised to the nominal temperature of evaporation of chromium and the flow of argon has been stopped. The internal surface of the walls of the plasma furnaces and of the crucibles of the zinc evaporator assemblies 38 and 39 have been brought to the nominal temperature for the evaporation of zinc with a similar procedure as described in section G.1.

### Typical working conditions:

- 20 rebars coated in parallel
- Rebar diameter: 25.4 mm
- Line speed: 0.3 m/s
- Throughput: 86 T/hour
- Coating thickness: 50 µm
- Zinc evaporation power: 197 kW per plasma evaporator
- Zinc consumption: 298 kg/hour per evaporator
- Zinc plasma furnace heating power: 6 kW per plasma furnace
- Chromium evaporation power: 62 kW per plasma evaporator
- Chromium consumption: 9 kg/hour per plasma evaporator
- Chromium plasma furnace heating power: < 44 kW per plasma furnace
- Temperature increases of the rebars due to coating: < 39°C

### H.10. Equipment adapted to PET web metallization

Batch metallizers use currently BN-TiB₂ or BN-TiB₂-AlN boats for aluminum evaporation by Joule heating under high vacuum. The lifetime of such boats is limited to 15 hours maximum. For coating of webs of several meters in width, numerous boats and respective aluminum wire feeding systems are necessary. The post-magnetron plasma evaporator in a plasma furnace whose magnetic field is produced by a Halbach array brings a major improvement to that situation. Indeed, i) the numerous crucibles needed by the current technology is replaced by only one long plasma evaporator, ii) heating the aluminum by plasma evaporation allows longer life time of the crucible than by Joule heating and iii) no continuous feeding of aluminum is required, the full amount of aluminum for coating up to 50'000 m of web being stored in the crucible.

For aluminum coating on a polyethylene terephthalate (PET) web, the web is supported on a cooling drum facing closely the flange 22 at the opening of the plasma furnace 8 or 9. The flange 22 has a cylindrical shape to follow the shape of the drum and allows a clearance of maximum several millimeters to limit aluminum vapor losses to the vacuum vessel volume that contains the equipment. The plasma furnace setup that is used for web metallization is typically the one presented in Figure 9 but with opening at the flange 22 oriented horizontally, instead of vertically, and facing the cooling drum supporting the web at short distance to limit clearances and aluminum losses toward the vacuum vessel volume.

### Typical working conditions:

- PET web width: 4000 mm
- PET web thickness: 15 µm
- Line speed: 20 m/s
- Processing time per batch: 42 min
- Coating thickness: 30 nm, one side coated
- Plasma evaporation power: < 100 kW
- Aluminum consumption: 23 kg/hour
- Weight of aluminum in plasma evaporator (no need for continuous feeding): 16 kg
- Plasma furnace heating power: 35 kW

## Claims

1. Method for heating walls (17) delimiting an internal volume (19) in a vacuum furnace (8,9,30), said walls (17) forming a thermal shield (28) and having an electric conductive surface (20) directed towards said internal volume (19), wherein a plasma is generated in a gas at a pressure lower than 1 mbar in the internal volume (19) between said walls (17) and an anode (18) present in the internal volume (19), **characterised in that** a voltage bias is generated between the plasma and said surface (20) of the walls (17) by polarising said surface (20) negatively with respect to the anode (18) and wherein the temperature of said walls (17), in particular of said surface (20), is regulated by regulating the power transfer of the plasma to the walls (17) by controlling the electrical power supply through said voltage bias.

2. Method according to claim 1, wherein the surface area of said anode (18) in said internal volume (19) is smaller than the total area of the side of said walls (17) directed towards said internal volume (19).

3. Method according to claim 1 or 2, wherein said gas is an inert gas comprising at least one of helium, argon, neon or xenon, that is introduced into the internal volume (19) in which a pressure is maintained between preferably 0.001 and 0.1 mbar.

4. Method according to any of claims 1 tot 3, wherein a crucible (21) containing a material is present in said internal volume (19) and is polarized negatively against said anode (18) and said material is evaporated in said internal volume (19) in order to produce a vapor of said material and, when a preset temperature is reached at said electric conductive surface (20) of the walls (17), supply of said gas to the internal volume is ceased and the plasma is maintained in said vapor.

5. Method according to claim 4, wherein power transfer of the plasma to the material in the crucible (21) is raised, for evaporating said material, by raising the electrical power supply through the voltage bias between the crucible (21) containing the material and said anode (18).

6. Method according to claim 4 or 5, wherein a magnetic field (B) is generated in said internal volume (19) oriented substantially parallel to the surface of said material contained in said crucible (21) to enable a post-magnetron discharge.

7. Method for treatment of at least a substrate in a vacuum furnace (8,9,30) having walls (17) heated by applying the method of any of claims 4 to 6, wherein the substrate (5) is brought into contact with said vapor while the substrate (5) is electrically insulated from said walls (17) and from said anode (18).

8. Method according to claim 7,wherein said substrate (5) is brought into contact with said vapor after said preset temperature has been reached at the surfaces (20) of the walls (17) directed towards the internal volume (19) and after terminating supply of gas to the internal volume (19).

9. Method according to claim 7 or 8, wherein said substrate (5) is kept thermally shielded from said internal volume (19) until at least said preset temperature is reached at the surfaces (20) of the walls (17) directed towards the internal volume (19).

10. Method according to any of claims 7 to 9, wherein the electrical power delivered through the voltage bias between the crucible (21) containing the material and said anode (18) is raised after said substrate (5) is brought into contact with the vapor.

11. Method according to any of claims 7 to 10, wherein, when terminating treatment of said substrate (5), said electrical power is switched off and pressure of said gas in the internal volume (19) is raised to a pressure higher than 0.1 mbar, preferably between 1 and 10 mbar for cooling said walls (17) to a temperature threshold and said internal volume (19) is subsequently vented to atmospheric pressure.

12. Device for plasma treatment of a substrate, comprising a vacuum furnace (8,9,30) having an internal volume (19) delimited by walls (17) forming a thermal shield (28) and having a side directed towards said internal volume (19), said side having an electric conductive surface (20), wherein an anode (18) is provided in the internal volume (19) permitting to generate a plasma in the internal volume (19), **characterised in that** said electric conductive surface (20) of the walls (17) is adapted to be negatively polarised against said anode (18), wherein a power supply is provided permitting to apply voltage bias between the plasma and said electric conductive surface (20) of the walls (17) by polarising said electric conductive surface (20) negatively with respect to the anode (18) and wherein a controller is provided for regulating the temperature of said surface (20) by regulating the power transfer of the plasma to the walls (17) by controlling the electrical power supply through said voltage bias.

13. Device according to claim 12, wherein said internal volume (19) communicates with a treatment zone for said substrate (5) via a treatment opening (23) and wherein a door (14,15), forming a thermal shield (28), is provided allowing to close said treatment opening (23).

14. Device according to claim 12 or 13, wherein said walls (17) comprise an electric insulating layer adjacent said electric conductive surface.

15. Device according to any of claims 12 to 14, wherein said internal volume (19) comprises at least one crucible (21) for containing a material to be vaporised, wherein said crucible (21) is provided to be negatively polarised against said anode (18).

16. Device according to claim 15, wherein said crucible (21) is made of electrically conducting refractory materials.

17. Device according to any of claims 12 to 16, wherein the surface area of said anode (18) in said internal volume (19) is smaller than the total area of said side of the walls (17) directed towards said internal volume (19).

18. Device according to claim 17, wherein the surface area of said anode (18) is less than the 10% of said total area of said side of the walls (17).

19. Device according to any of claims 12 to 18, wherein a cooled shield is provided at the side of the walls (17) external with respect to said internal volume (19).

20. Device according to claim 19, wherein said cooled shield is at the same electric potential as the electric potential of said electric conductive surface (20) of the walls (17).

21. Device according to claim 19 or 20, wherein the surface of the cooled shield facing away from said walls (17) is covered by an electrically insulating material or a metallic electric shield extending at a distance of less than 5 mm from said surface of the cooled shield and electrically insulated from the cooled shield.

22. Device according to any of claims 12 to 21, wherein said walls (17) forming a thermal shield (28) comprise a stack of successive metal sheets spaced from each other.

23. Device according to any of claims 12 to 22, wherein said device is contained in a vacuum vessel (1).

24. Device according to any of claims 12 to 23, wherein a support (32) for said substrate (5) is provided, said support (32) electrically insulating the substrate (5) from said walls (17), in particular from said internal surface (20).

25. Device according to any of claims 12 to 23, wherein said support (32) is connecting the substrate (5) to an additional power supply.
